# EUROPÄISCHE PATENTSCHRIFT

(11) **EP 3 240 133 B1**
(45) Veröffentlichungstag und Bekanntmachung des Hinweises auf die Patenterteilung: **12.12.2018**
(21) Anmeldenummer: 16167507.9
(22) Anmeldetag: 28.04.2016
(51) Int. Cl.: H02H 9/04, H04L 12/40, H03K 17/06, H04L 12/933

(54) **BUSTEILNEHMER**
BUS PARTICIPANTS
PARTICIPANTS D'UN BUS

(43) Veröffentlichungstag der Anmeldung: 01.11.2017
(73) Patentinhaber: Siemens Aktiengesellschaft, 80333 München (DE)
(72) Erfinder: SCHARF, Alexander, 76870 Kandel (DE)

(56) Entgegenhaltungen:
- CN-A- 102 780 204
- CN-U- 201 797 293
- DE-A1- 19 926 095
- US-A1- 2010 306 562
- US-B2- 7 145 378

## Beschreibung

Die Erfindung betrifft eine Anordnung mit mindestens zwei Busteilnehmern, einer ihnen gemeinsamen und an zwei Stromleitungen angeschlossenen Spannungsquelle sowie einem mindestens eine Busleitung aufweisenden Bus, wobei jeder der Busteilnehmer jeweils zwei Stromversorgungsanschlüsse zum Anschluss an die zwei Stromleitungen, mindestens einen Busleitungsanschluss zum Anschluss an den Bus und eine Busschnittstellenschaltung zur Steuerung eines Datenverkehrs über den Bus aufweist.

Eine derartige Anordnung ist aus der EP 1 612 689 B1 bekannt.

Unter Busteilnehmern sind Geräte zu verstehen, die, z. B. im Rahmen der Automatisierung einer technischen Anlage, bestimmte Funktionen erfüllen und dazu untereinander oder mit einer übergeordneten Einrichtung, z. B. einer Steuereinrichtung, Daten über einen Bus austauschen. Zur Stromversorgung der Busteilnehmer können diese über zwei Stromleitungen aus einer gemeinsamen Spannungsquelle gespeist werden. Die Busteilnehmer weisen dann zwei Stromversorgungsanschlüsse auf, mit denen sie parallel an die beiden Stromleitungen angeschlossen werden. Der Bus kann aus einer oder mehreren Busleitungen bestehen. Im Falle nur einer Busleitung bildet eine der Stromleitungen den Rückleiter. Zum Anschluss an den Bus weisen die Busteilnehmer eine der Anzahl der Busleitungen entsprechende Zahl von Busleitungsanschlüssen auf. Bei den Stromversorgungs- und Busleitungsanschlüssen kann es sich beispielsweise um Anschlussklemmen oder um Kontakte eines Steckverbinders handeln. Jeder Busteilnehmer enthält eine Busschnittstellenschaltung (Bustreiber), die den Datenverkehr über den Bus steuert.

Es sind unterschiedlichste Bussysteme bekannt. So sieht beispielsweise der weit verbreitete Standard RS-485 eine asynchrone serielle Datenübertragung auf zwei Busleitungen vor, wobei auf der einen Busleitung ein invertierter Pegel und auf der anderen Busleitung ein nichtinvertierter Pegel eines 1-Bit-Datensignals übertragen wird und empfängerseitig das ursprüngliche Datensignal aus der Differenz der beiden Spannungspegel rekonstruiert wird.

Wenn ein Busteilnehmer mit der Stromversorgung und dem Bus verbunden oder von diesen getrennt wird, also beispielsweise beim Stecken oder Ziehen eines als Baugruppe ausgebildeten Busteilnehmers, kommt es in der Regel dazu, dass die elektrischen Verbindungen zwischen den einzelnen Anschlüssen des Busteilnehmers und den zugehörigen Bus- und Stromleitungen nicht gleichzeitig hergestellt bzw. unterbrochen werden. Dies kann zu einem Querstrom auf dem Bus führen, wenn der Busteilnehmer versucht, eine einseitig noch nicht hergestellte oder unterbrochene Stromversorgung über eine bereits oder noch bestehende Busverbindung herzustellen bzw. aufrecht zu erhalten. Selbst wenn ein solcher kritischer Zustand nur von sehr kurzer Dauer ist, kann ein solcher Querstrom ausreichen, die Busschnittstellenschaltungen und ggf. vorhandene Schutzschaltungen zu zerstören. Es ist zwar möglich, die Busschnittstellenschaltungen galvanisch von den übrigen Komponenten in den Busteilnehmern zu trennen, jedoch ist dies mit einem vergleichsweise hohen Bauteileaufwand verbunden und beeinträchtigt darüber hinaus die Datenübertragung.

Die US 7,145,378 B2 offenbart einen konfigurierbaren Bus-Schalter in Form einer Gruppe von einzelnen Schaltern zum Schalten und Trennen von Busleitungen. Eine Steuerlogik decodiert ein fünfstelliges Enable-Signal in individuelle Schaltsignale für die hier zwanzig einzelnen Schalter. Eine Schaltung mit einer programmierbaren Diode ermöglicht es, in Abhängigkeit von einem Steuersignal eine Spannungspegelverschiebung an den Schaltern vorzunehmen.

Aus der US 2010/0306562 A1 ist ein DC-DC-Wandler als Bestandteil einer Stromversorgung eines Computers bekannt. Damit der DC-DC-Wandler beim Übergang des Computers von einem Normalzustand in einen Ruhezustand nicht in einen ungewünschten Zustand gerät, überwacht eine Sensorschaltung die Betriebsspannung und verbindet durch Schließen eines MOSFET-Schalters einen Disable-Eingang des DC-DC-Wandlers mit Masse, wenn die erfasste Spannung einen Schwellenwert unterschreitet. Die Sensorschaltung enthält einen Spannungsteiler und einen Transistor, wobei die zu erfassende Spannung an dem Spannungsteiler anliegt, der Transistor mit seiner Basis-Emitter-Strecke an einem Zweig des Spannungsteilers liegt und über seinen Kollektor den Schalter steuert.

Aus der CN 102780204 A ist eine Unterspannungsschutzschaltung mit einem MOSFET-Schalter bekannt, der eine Last von einer Stromversorgung trennt, wenn deren Spannung unter einen Schwellenwert sinkt. Der MOSFET-Schalter wird von einer die Spannung erfassenden Sensorschaltung gesteuert, die ebenfalls einen Spannungsteiler und einen Transistor enthält, wobei die zu erfassende Spannung an dem Spannungsteiler anliegt, der Transistor mit seiner Basis-Emitter-Strecke an einem Zweig des Spannungsteilers liegt und über seinen Kollektor den Schalter steuert.

Aus der DE 199 26 095 A1 ist ein Interface zum Ankoppeln eines Busteilnehmers an die Busleitung eines Bussystems, insbesondere an das Bussystem EIB bekannt. Bei diesem Bussystem erfolgen Spannungsversorgung und Datenübertragung auf ein und demselben Leiterpaar. Bei erhöhtem Strombedarf des Busteilnehmers kann dieser aus einer externen Spannungsversorgung gespeist werden, wobei das Interface, über das der Busteilnehmer an dem EIB angeschlossen ist, aus dem EIB versorgt wird. Das Interface erzeugt ein Steuersignal für den Busteilnehmer, mit dem dieser für den Empfang und die Übertragung von Daten erst dann freigeschaltet wird, wenn zum einen die Versorgungsspannung des Busteilnehmers und zum anderen auch die Busspannung ausreichend sind bzw. vorgegebene Werte erreicht haben.

Der Erfindung liegt die Aufgabe zugrunde, zum Anschluss an eine gemeinsame Stromversorgung vorgesehene Busteilnehmer mit einfachen Mitteln vor ungewünschten Querströmen auf dem Bus zu schützen.

Gemäß der Erfindung wird die Aufgabe dadurch gelöst, dass bei der Anordnung der eingangs angegebenen Art in jedem der Busteilnehmer zwischen seiner Busschnittstellenschaltung und seinem mindestens einen Busleitungsanschluss ein steuerbarer Schalter liegt und dass der Busteilnehmer eine Sensorschaltung enthält, die dazu ausgebildet ist, die Spannung zwischen seinen Stromversorgungsanschlüssen oder eine daraus abgeleitete Spannung zu erfassen und den steuerbaren Schalter zu schließen, wenn die erfasste Spannung einen Schwellenwert überschreitet und zu öffnen, wenn die erfasste Spannung den Schwellenwert unterschreitet, um einen Querstrom über den Bus zu verhindern, wenn bei einem der Busteilnehmer nur einer seiner Stromversorgungsanschlüsse mit der zugeordneten Stromleitung verbunden ist.

Unter der abgeleiteten Spannung ist dabei eine elektrische Spannung zu verstehen, die in dem Busteilnehmer beispielsweise durch Spannungsteilung oder durch Spannungswandlung aus der Spannung zwischen den Stromversorgungsanschlüssen erzeugt wird.

Bei dem erfindungsgemäßen Busteilnehmer wird also die Verbindung zwischen der Busschnittstellenschaltung und dem Bus erst dann hergestellt, wenn ein Betriebsspannungsniveau des Busteilnehmers, also das Spannungsniveau im regulären Betrieb, erreicht ist. Die Verbindung wird unterbrochen, wenn das Betriebsspannungsniveau unterschritten wird. Bei der Betriebsspannung muss es sich nicht notwendigerweise um die Speisespannung handeln, die der Busteilnehmer über die Stromversorgungsleitungen erhält. So kann der Busteilnehmer einen DC-DC-Wandler enthalten, der die Speisespannung in eine oder mehrere stabile Ausgangsspannungen zur Versorgung der Busschnittstellenschaltung und/oder weiterer interner Komponenten umsetzt. In diesem Fall kann die Sensorschaltung eine dieser Ausgangsspannungen erfassen und auf die Schwellenwertüber- bzw. -unterschreitung überprüfen.

Bei zwei oder mehr Busleitungsanschlüssen kann für jeden der zwei oder mehr steuerbaren Schalter jeweils eine eigene Sensorschaltung vorgesehen sein oder es können alle steuerbaren Schalter gemeinsam von einer Sensorschaltung angesteuert werden. Es kann auch vorgesehen werden, dass der Schaltungsteil der Sensorschaltung, der unmittelbar die Spannung erfasst, nur einmal vorhanden ist, während jeder Schalter von einem individuell zugeordneten Schaltungsteil angesteuert wird. Im Einzelfall ist dabei entscheidend, dass durch das Design der Sensorschaltung bzw. die verwendeten Bauelemente eine auseichende elektrische Potentialtrennung zwischen den Busleitungen gewährleistet wird.

Gemäß einer vorteilhaften Ausführung des erfindungsgemäßen Busteilnehmers wird der gewünschte Schutz mit minimalem Aufwand dadurch erreicht, dass die Sensorschaltung einen Spannungsteiler und einen Transistor enthält, wobei die zu erfassende Spannung an dem Spannungsteiler anliegt, der Transistor mit seiner Basis-Emitter-Strecke an einem Zweig des Spannungsteilers liegt und über seinen Kollektor den Schalter steuert. Der steuerbare Schalter besteht vorzugsweise aus einem MOSFET. Der Schwellenwert der Sensorschaltung wird durch die Basis-Emitter-Schleusenspannung des Transistors gebildet. Der Typ des Transistors und des MOSFETs sind im Hinblick auf die Polarität der überwachten Spannung so gewählt, dass bei dem Spannungswert Null, also im stromlosen Zustand, der Transistor und der MOSFET sperren.

Bei zwei oder mehr Busleitungsanschlüssen und dementsprechend zwei oder mehr steuerbaren Schaltern bzw. MOSFETs können alle steuerbaren Schalter gemeinsam von einem Transistor gesteuert werden. Es kann auch vorgesehen werden, dass der Spannungsteiler nur einmal vorhanden ist, während für jeden MOSFET ein eigener Transistor vorgesehen ist.

Neben dem erfindungsgemäßen Busteilnehmer ist auch eine Anordnung mit mindestens zwei solchen Busteilnehmern Gegenstand der Erfindung, wobei die Busteilnehmer mit ihren Busleitungsanschlüssen an einem mindestens eine Busleitung aufweisenden Bus und mit ihren Stromversorgungsanschlüssen über zwei Stromleitungen an einer gemeinsamen Spannungsquelle angeschlossen sind.

Zur weiteren Erläuterung der Erfindung wird im Folgenden auf die Figuren der Zeichnung Bezug genommen; im Einzelnen zeigen jeweils in schematischer Darstellung:
- Figur 1: ein Ausführungsbeispiel einer Anordnung mit zwei Busteilnehmern entsprechend der Erfindung, die
- Figuren 2 und 3: zwei detailliertere Ausführungsbeispiele eines der Busteilnehmer und die
- Figuren 4 und 5: unterschiedliche Modifikation des Ausführungsbeispiels nach Figur 2.

Gleiche Bezugszeichen haben in den verschiedenen Figuren die gleiche Bedeutung.

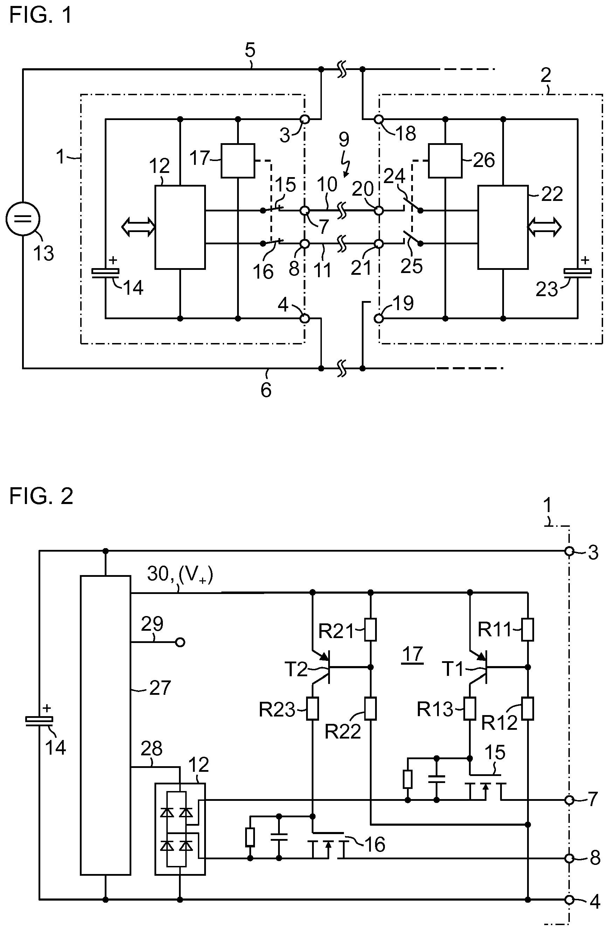

Figur 1 zeigt eine Anordnung mit zwei Busteilnehmern 1, 2, die gleich aufgebaut sind und von denen hier nur für die Erfindung relevante Komponenten dargestellt sind.

Der Busteilnehmer 1 weist zwei Stromversorgungsanschlüsse 3, 4 zum Anschluss an zwei Stromversorgungsleitungen 5, 6, zwei Busleitungsanschlüsse 7, 8 zum Anschluss an einen Bus 9 mit zwei Busleitungen 10, 11 und eine Busschnittstellenschaltung 12 auf, die den Datenfluss über den Bus 9 steuert. Der Busteilnehmer 1 wird über die beiden Stromversorgungsleitungen 5, 6 aus einer Spannungsquelle 13 mit der von ihm benötigten Energie versorgt. Dabei dient ein kapazitiver Puffer 14 zur Zwischenspeicherung der zugeführten Energie, um einen kurzfristig erhöhten Leistungsbedarf des Busteilnehmers 1 abzudecken. Die Busschnittstellenschaltung 12 ist mit den Busleitungsanschlüssen 7, 8 nicht unmittelbar sondern über steuerbare Schalter 15, 16 verbunden. Die Schalter 15, 16 werden von einer Sensorschaltung 17 gesteuert, die die Spannung zwischen den Stromversorgungsanschlüssen 3, 4 erfasst und die steuerbaren Schalter 15, 16 schließt, wenn die erfasste Spannung einen Schwellenwert überschreitet und zu öffnen, wenn die erfasste Spannung den Schwellenwert unterschreitet.

Der andere Busteilnehmer 2 ist genauso wie der Busteilnehmer 1 aufgebaut und weist zwei Stromversorgungsanschlüsse 18, 19 zum Anschluss an die Stromversorgungsleitungen 5, 6, zwei Busleitungsanschlüsse 20, 21 zum Anschluss an den Bus 9, eine Busschnittstellenschaltung 22, einen kapazitiven Puffer 23, zwei steuerbare Schalter 24, 25 zwischen den Busleitungsanschlüssen 20, 21 und der Busschnittstellenschaltung 22 sowie eine Sensorschaltung 26 auf.

Die beiden Busteilnehmer 1, 2 sollen gemeinsam aus der Spannungsquelle 13 gespeist werden und über den Bus 9 miteinander kommunizieren. Es sei angenommen, dass der Busteilnehmer 1 über seine Anschlüsse 3, 4, 7, 8 bereits mit den Stromversorgungsleitungen 5, 6 und den Busleitungen 10, 11 verbunden ist. Der kapazitive Puffer 14 ist auf die Spannung der Spannungsquelle 13 aufgeladen. Wenn jetzt der andere Busteilnehmer 2 ebenfalls an die Stromversorgung den Bus angeschlossen werden soll, kann es passieren, dass die Verbindung zwischen einer der Stromversorgungsleitungen, hier z. B. 5, und dem zugehörigen Stromversorgungsanschluss 18 sowie die Verbindung zwischen einer oder beiden Busleitungen 10, 11 und den zugehörigen Busleitungsanschlüssen 20, 21 bereits hergestellt ist, während die Verbindung zwischen der Stromversorgungsleitung 6 und dem zugehörigen Stromversorgungsanschluss 19 noch offen ist. Da der kapazitive Puffer 23 noch nicht aufgeladen ist, liegt der Stromversorgungsanschluss 19 etwa auf demselben elektrischen Potential wie der Stromversorgungsanschluss 18. Die Spanungsquelle 13 und/oder der Busteilnehmer 1 versuchen daher, als Ersatz für die fehlende Verbindung zwischen den Stromversorgungsanschlüssen 4 und 19 einen Stromweg von der Stromleitung 5 über die Busschnittstellenschaltung 22, den Bus 9 und die Busschnittstellenschaltung 12 zu der Stromleitung 6 herzustellen, wobei bei entsprechend hoher Spannung der Spannungsquelle 13 der resultierende Querstrom auf dem Bus 9 die beiden Busschnittstellenschaltungen 12, 22 zerstören kann. Ein solcher Querstrom wird dadurch verhindert, dass die Sensorschaltung 26 feststellt, dass die von ihr erfasste Spannung zwischen den Stromversorgungsanschlüssen 18 und 19 den vorgegebenen Schwellenwert unterschreitet, und infolgedessen die Schalter 24 und 25 offen hält. Erst wenn die Verbindung zwischen der Stromversorgungsleitung 6 und dem zugehörigen Stromversorgungsanschluss 19 hergestellt ist und der kapazitive Puffer 23 so weit aufgeladen ist, dass die Spannung zwischen den Stromversorgungsanschlüssen 18 und 19 den vorgegebenen Schwellenwert überschreitet, werden die Schalter 24 und 25 geschlossen.

Figur 2 zeigt in detaillierterer Darstellung ein abgewandeltes Ausführungsbeispiel des Busteilnehmers 1 mit den Stromversorgungsanschlüssen 3, 4, den Busleitungsanschlüsse 7, 8, der Busschnittstellenschaltung 12, dem kapazitiven Puffer 14, den steuerbaren Schalter 15, 16 und der Sensorschaltung 17. Im Unterschied zu dem Beispiel nach Figur 1 enthält der Busteilnehmer 1 einen DC-DC-Wandler 27, der an Ausgängen 28, 29, 30 unterschiedliche Spannungen zur Versorgung der Busschnittstellenschaltung 12 und ggf. weiterer, hier nicht gezeigter, Komponenten bereitstellt. Die Sensorschaltung 17 überwacht die von dem DC-DC-Wandler 27 an seinem Ausgang 30 erzeugte Spannung V+ und ist für die beiden als n-Kanal MOSFETs ausgebildeten steuerbaren Schalter 15, 16 doppelt ausgelegt. Die Sensorschaltung 17 enthält für jeden der beiden Schalter 15, 16 jeweils einen aus Widerständen R11, R12 bzw. R21, R22 gebildeten Spannungsteiler, der zwischen dem Ausgang 30 des DC-DC-Wandlers 27 und dem als Masse dienenden Stromversorgungsanschluss 4 liegt. Ein pnp-Transistor T1, T2 liegt mit seiner Basis-Emitter-Strecke an dem von dem Widerstand R11 bzw. R21 gebildeten Zweig des Spannungsteilers und steuert über seinen Kollektor und einen Vorwiderstand R13, R23 den jeweiligen MOSFET-Schalter 15 bzw. 16. Der Schwellenwert der Sensorschaltung 17 wird durch die Basis-Emitter-Schleusenspannung der Transistoren T1, T2 und das Spannungsteilerverhältnis bestimmt. Wenn also z. B. die Spannung V₊·(R11/(R11+R12)) kleiner als die Basis-Emitter-Schleusenspannung des Transistors T1 ist, sind der Transistor T1 und der MOSFET-Schalter 15 nichtleitend, d. h. der Schalter 15 ist geöffnet. Gleiches gilt für den Schalter 16.

Bei der Busschnittstellenschaltung 12 ist eine interne Schutzschaltung mit Schutzdioden dargestellt. Hier zeigt sich nochmal deutlich das in Verbindung mit Figur 1 beschriebene Problem, dass z. B. bei geschlossenem Schalter 15 ein von dem Potential auf der Stromversorgungsleitung 5 getriebener und von dem Bus 9 kommender Querstrom über den Busleitungsanschluss 7, den Schalter 15, die Busschnittstellenschaltung 12, und den Ausgang 28 des DC-DC-Wandlers 27 zur Masse (Stromversorgungsanschluss 4) fließen kann.

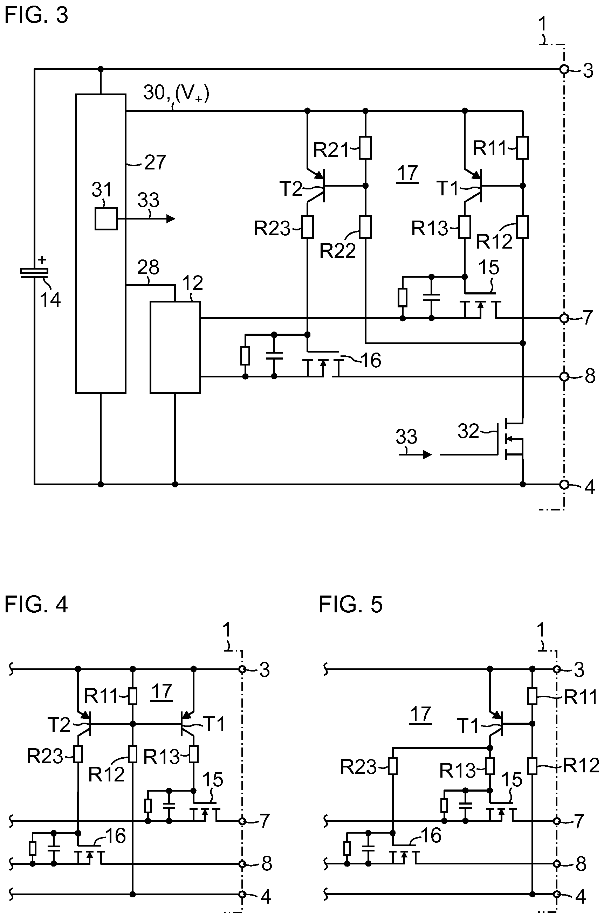

Das in Figur 3 gezeigte Ausführungsbeispiel des erfindungsgemäßen Busteilnehmers 1 unterscheidet sich von dem nach Figur 2 dadurch, dass eine in dem Busteilnehmer 1, hier in dem DC-DC-Wandler 27, vorhandene Schaltung 31 zur Unterspannungserkennung genutzt wird, um die Schalter 15, 16 zu steuern. Dazu sind die Spannungsteiler R11, R12 und R21, R22 nicht unmittelbar sondern über einen weiteren MOSFET-Schalter 32 mit dem Stromversorgungsanschluss 4 verbunden. Bei normaler Betriebsspannung erzeugt die Schaltung 31 eine Steuerspannung 33, die den MOSFET-Schalter 32 in einen leitenden Zustand steuert. Bei Unterspannung bzw. Spannungsausfall fällt diese Steuerspannung 33 weg, so dass der MOSFET-Schalter 32 und in der Folge die Transistoren T1, T2 und die MOSFET-Schalter 15, 16 jeweils in den sperrenden Zustand übergehen.

Wie Figur 4 zeigt, können die in den Figuren 2 und 3 gezeigten zwei Spannungsteiler durch einen einzigen Spannungsteiler R11, R12 ersetzt werden, wobei die Transistoren T1, T2 mit ihren Basis-Emitter-Strecken gemeinsam an dem von dem Widerstand R11 gebildeten Zweig des Spannungsteilers liegen und über ihre Kollektoren und die Vorwiderstände R13, R23 die MOSFET-Schalter 15, 16 steuern.

Bei dem in Figur 5 gezeigten Ausführungsbeispiel entfällt der Transistor T2 und der Transistor T1 steuert gleichzeitig beide MOSFET-Schalter 15, 16 über seinen Kollektor und die Vorwiderstände R13, R23.

## Patentansprüche

1. Anordnung mit mindestens zwei Busteilnehmern (1; 2), einer ihnen gemeinsamen und an zwei Stromleitungen (5, 6) angeschlossenen Spannungsquelle (13) sowie einem mindestens eine Busleitung (10, 11) aufweisenden Bus (9), wobei jeder der Busteilnehmer (1; 2) jeweils zwei Stromversorgungsanschlüsse (3, 4; 18, 19) zum Anschluss an die zwei Stromleitungen (5, 6), mindestens einen Busleitungsanschluss (7, 8; 20, 21) zum Anschluss an den Bus (9) und eine Busschnittstellenschaltung (12; 22) zur Steuerung eines Datenverkehrs über den Bus (9) aufweist, **dadurch gekennzeichnet, dass** in jedem der Busteilnehmer (1; 2) zwischen seiner Busschnittstellenschaltung (12; 22) und seinem mindestens einen Busleitungsanschluss (7, 8; 20, 21) ein steuerbarer Schalter (15, 16; 24, 25) liegt und dass jeder Busteilnehmer (1; 2) eine Sensorschaltung (17; 26) enthält, die dazu ausgebildet ist, die Spannung zwischen seinen Stromversorgungsanschlüssen (3, 4; 18, 19) oder eine daraus abgeleitete Spannung zu erfassen und den steuerbaren Schalter (15, 16; 24, 25) zu schließen, wenn die erfasste Spannung einen Schwellenwert überschreitet und zu öffnen, wenn die erfasste Spannung den Schwellenwert unterschreitet, um einen Querstrom über den Bus (9) zu verhindern, wenn bei einem der Busteilnehmer (z. B. 2) nur einer seiner Stromversorgungsanschlüsse (z. B. 18) mit der zugeordneten Stromleitung (5) verbunden ist.

2. Anordnung nach Anspruch 1, **dadurch gekennzeichnet, dass** jeder der Busteilnehmer (z. B. 1) jeweils einen DC-DC-Wandler (27) zur Stromversorgung seiner Busschnittstellenschaltung (12) aus der über die Stromversorgungsleitungen (5, 6) erhaltenen Spannung enthält und dass seine Sensorschaltung (17) eine Ausgangsspannung des DC-DC-Wandlers (27) erfasst.

3. Anordnung nach Anspruch 1 oder 2, **dadurch gekennzeichnet, dass** die Sensorschaltung (17) einen Spannungsteiler (R11, R12; R21, R22) und einen Transistor (T1; T2) enthält, wobei die zu erfassende Spannung (V₊) an dem Spannungsteiler (R11, R12; R21, R22) anliegt, der Transistor (T1; T2) mit seiner Basis-Emitter-Strecke an einem Zweig (R11; R21) des Spannungsteilers (R11, R12; R21, R22) liegt und über seinen Kollektor den Schalter (15; 16) steuert.

4. Anordnung nach Anspruch 3, **dadurch gekennzeichnet, dass** der steuerbare Schalter (15, 16) aus einem MOSFET besteht.

5. Anordnung nach Anspruch 3 oder 4, **dadurch gekennzeichnet, dass** die zu erfassende Spannung (V₊) über einen weiteren steuerbaren Schalter (32) an dem Spannungsteiler (R11, R12; R21, R22) anliegt und der Busteilnehmer (1) eine Schaltung (31) zur Unterspannungserkennung enthält, die bei Unterspannung den Spannungsteiler (R11, R12; R21, R22) von der zu erfassenden Spannung (V₊) trennt.

6. Anordnung nach Anspruch 5, **dadurch gekennzeichnet, dass** der weitere steuerbare Schalter (32) aus einem MOSFET besteht.

## Claims

1. Arrangement with at least two bus subscribers (1; 2), a voltage source (13) shared therebetween and connected to two current lines (5, 6) as well as a bus (9) having at least one bus line (10, 11), wherein each of the bus subscribers (1; 2) has in each case two power supply terminals (3, 4; 18, 19) for connection to the two current lines (5, 6), at least one bus line terminal (7, 8; 20, 21) for connection to the bus (9) and a bus interface circuit (12; 22) for controlling a data traffic by way of the bus (9), **characterised in that** a controllable switch (15, 16; 24, 25) is located in each of the bus subscribers (1; 2) between its bus interface circuit (12; 22) and its at least one bus line terminal (7, 8; 20, 21) and that each bus subscriber (1; 2) contains a sensor circuit (17; 26), which is embodied to record the voltage between its power supply terminals (3, 4; 18, 19) or a voltage derived therefrom and to close the controllable switch (15; 16; 24, 25) if the recorded voltage exceeds a threshold value and to open the same if the recorded voltage does not reach the threshold value in order to prevent a cross current via the bus (9) if, with one of the bus subscribers (e.g. 2), only one of its power supply terminals (e.g. 18) is connected with the assigned current line (5).

2. Arrangement according to claim 1, **characterised in that** each of the bus subscribers (e.g. 1) contains in each case a DC-DC converter (27) to supply power to its bus interface circuit (12) from the voltage obtained by way of the power supply lines (5, 6) and that its sensor circuit (17) records an output voltage of the DC-DC converter (27).

3. Arrangement according to claim 1 or 2, **characterised in that** the sensor circuit (17) contains a voltage divider (R11, R12; R21, R22) and a transistor (T1; T2), wherein the voltage (V₊) to be recorded is present on the voltage divider (R11, R12; R21, R22), the transistor (T1; T2) with its base emitter path is located on a branch (R11; R21) of the voltage divider (R11, R12; R21, R22) and controls the switch (15; 16) by way of its collector.

4. Arrangement according to claim 3, **characterised in that** the controllable switch (15; 16) consists of a MOSFET.

5. Arrangement according to claim 3 or 4, **characterised in that** the voltage (V₊) to be recorded by way of a further controllable switch (32) is present on the voltage divider (R11, R12; R21, R22) and the bus subscriber (1) contains a circuit (31) for identifying low voltage, which, in the case of a low voltage, separates the voltage divider (R11, R12; R21, R22) from the voltage (V₊) to be recorded.

6. Arrangement according to claim 5, **characterised in that** the further controllable switch (32) consists of a MOSFET.

## Revendications

1. Système ayant au moins deux participants (1; 2) de bus, une source (13) de tension, qui leur est commune et qui est raccordée à deux lignes (5, 6) de courant, ainsi qu'un bus (9) ayant au moins une ligne (10, 11) de bus, chacun des participants (1; 2) de bus ayant respectivement deux bornes (3, 4; 18, 19) d'alimentation en courant pour le raccordement aux deux lignes (5, 6) de courant, au moins une borne (7, 8; 20, 21) de ligne de bus pour le raccordement au bus (9) et un circuit (12; 22) d'interface de bus pour commander un trafic de données par l'intermédiaire du bus (9), **caractérisé en ce qu'**il y a, dans chacun des participants (1; 2) de bus, entre son circuit (12; 22) d'interface de bus et sa au moins une borne (7, 8; 20, 21) de ligne de bus, un interrupteur (15, 16; 24, 25) pouvant être commandé et **en ce que** chaque participant (1; 2) de bus contient un circuit (17; 26) de capteur, constitué pour détecter la tension entre ses bornes (3, 4; 18, 19) d'alimentation en courant ou une tension qui s'en déduit et pour fermer l'interrupteur (15, 16; 24, 25) pouvant être commandé, si la tension détectée dépasse une valeur de seuil, et pour l'ouvrir, si la tension détectée devient inférieure à la valeur de seuil, afin d'empêcher un courant transversal dans le bus (9) lorsque, pour l'un des participants de bus (par exemple 2), seule l'une de ses bornes (par exemple 18) d'alimentation en courant est reliée à la ligne (5) de courant associée.

2. Système suivant la revendication 1, **caractérisé en ce que** chacun des participants de bus (par exemple 1) comporte respectivement un convertisseur (27) courant continu-courant continu pour l'alimentation en courant de son circuit (12) d'interface de bus, à partir de la tension obtenue par les lignes (5, 6) d'alimentation en courant et **en ce que** son circuit (17) de capteur détecte une tension de sortie du convertisseur (27) courant continu-courant continu.

3. Système suivant la revendication 1 ou 2, **caractérisé en ce que** le circuit (17) de capteur comporte un diviseur (R11, R12; R21, 22) de tension et un transistor (T1; T2), la tension (V₊) à détecter s'appliquant au diviseur (R11, R12; R21, R22) de tension, le transistor (T1; T2) se trouvant, par sa section de base-émetteur, sur une branche (R11; R21) du diviseur (R11, R12; R21, R22) de tension et commandant l'interrupteur (15; 16) par son collecteur.

4. Système suivant la revendication 3, **caractérisé en ce que** l'interrupteur (15, 16) pouvant être commandé est constitué d'un MOSFET.

5. Système suivant la revendication 3 ou 4, **caractérisé en ce que** la tension (V₊) à détecter s'applique par un autre interrupteur (32) pouvant être commandé au diviseur (R11, R12; R21, R22) de tension et le participant (1) de bus contient un circuit (31) de détection d'une sous-tension, qui, s'il y a une sous-tension, sépare le diviseur (R11, R12; R21, R22) de tension de la tension (V₊) à détecter.

6. Système suivant la revendication 5, **caractérisé en ce que** l'autre interrupteur (32) pouvant être commandé est constitué d'un MOSFET.
